# EUROPÄISCHE PATENTANMELDUNG

(11) **EP 3 715 883 A1**
(43) Veröffentlichungstag der Anmeldung: **30.09.2020**
(21) Anmeldenummer: 19166211.3
(22) Anmeldetag: 29.03.2019
(51) Int. Cl.: G01R 31/14, G01R 31/34, G01R 31/12

(54) **ERFASSEN EINER TEILENTLADUNG**

(71) Anmelder: Siemens Aktiengesellschaft, 80333 München (DE)
(72) Erfinder: Meyer, Martin, 90425 Nürnberg (DE)

(57) **Zusammenfassung**

Die Erfindung betrifft eine Sensorvorrichtung (4) zum Erfassen einer Teilentladung. Die Sensorvorrichtung (4) umfasst einen Sensor (30), der eingerichtet ist, elektromagnetische Signale (S) zu erfassen, und ein Frequenzfilter (32), das eingerichtet ist, Messsignale (MS) des Sensors (30) mit Frequenzen in wenigstens einem Frequenzbereich zu unterdrücken, wobei der wenigstens eine Frequenzbereich einstellbar ist.

## Beschreibung

Die Erfindung betrifft eine Sensorvorrichtung und ein Verfahren zum Erfassen einer Teilentladung, insbesondere in einer an einem Stromrichter betriebenen rotierenden elektrischen Maschine.

Teilentladungen sind lokale elektrische Entladungen, welche beispielsweise in einem Isoliermaterial durch lokale Überschreitungen der Durchschlagfestigkeit des Isoliermaterials infolge starker Inhomogenitäten eines elektrischen Feldes verursacht werden. Teilentladungen können eine Isolierung lokal beschädigen und langfristig zum Versagen der Isolierung führen. Deshalb werden insbesondere rotierende elektrische Maschinen regelmäßig auf Teilentladungen untersucht. Teilentladungen verursachen kurze elektromagnetische Pulse mit Frequenzanteilen bis weit in den UHF-Frequenzbereich. Üblicherweise wird nach Teilentladungssignalen in Frequenzbereichen zwischen etwa 100 kHz und 10 MHz gesucht, in denen Teilentladungspulse in der Regel am stärksten sind.

Für die Erfassung von Teilentladungen gibt es eine Vielzahl von teilweise, beispielsweise nach DIN EN 60270, genormten Messverfahren. An rotierenden elektrischen Maschinen werden fast ausschließlich Offline-Messungen durchgeführt, bei denen der eigentliche Betrieb der elektrischen rotierenden Maschine unterbrochen wird. Wenn eine rotierende elektrische Maschine an einem Stromrichter betrieben wird, werden Teilentladungspulse von einer Vielzahl von Störsignalen überlagert, die von den Schaltvorgängen des Stromrichters verursacht werden. Für die Erfassung von Teilentladungen müssen diese Störsignale von den Teilentladungssignalen getrennt werden, um Teilentladungssignale nicht mit Störsignalen zu verwechseln.

Der Erfindung liegt die Aufgabe zugrunde, eine verbesserte Sensorvorrichtung und ein verbessertes Verfahren zum Erfassen einer Teilentladung, insbesondere in einer an einem Stromrichter betriebenen rotierenden elektrischen Maschine, anzugeben.

Die Aufgabe wird erfindungsgemäß durch eine Sensorvorrichtung mit den Merkmalen des Anspruchs 1, ein Verfahren mit den Merkmalen des Anspruchs 13 und eine Verwendung der Sensorvorrichtung mit den Merkmalen des Anspruchs 15 gelöst.

Vorteilhafte Ausgestaltungen der Erfindung sind Gegenstand der Unteransprüche.

Eine erfindungsgemäße Sensorvorrichtung zum Erfassen einer Teilentladung umfasst einen Sensor, der eingerichtet ist, elektromagnetische Signale zu erfassen, und ein Frequenzfilter, das eingerichtet ist, Messsignale des Sensors mit Frequenzen in wenigstens einem Frequenzbereich zu unterdrücken, wobei der wenigstens eine Frequenzbereich einstellbar ist.

Wie oben bereits angemerkt wurde, weisen von Teilentladungen verursachte elektromagnetische Pulse einen breiten Frequenzbereich mit Frequenzanteilen bis weit in den UHF-Bereich auf. In diesem Frequenzbereich treten auch elektromagnetische Signale auf, die nicht von Teilentladungen erzeugt und im Folgenden als Störsignale bezeichnet werden. Im Fall, dass die Sensorvorrichtung in einer rotierenden elektrischen Maschine angeordnet ist, können Störsignale beispielsweise von elektrischen Spannungen der elektrischen Maschine erzeugt werden. Wenn die elektrische Maschine von einem Stromrichter gespeist wird, erzeugen die Spannungen der elektrischen Maschine in der Regel eine Vielzahl von Störsignalen, die auf Schaltvorgänge des Stromrichters zurückgehen und Spektralanteile mit Frequenzen bis weit in den MHz-Bereich hinein aufweisen. Als weitere Störquellen kommen beispielsweise Funkdienste wie Rundfunk, Betriebsfunk oder Mobilfunk, unspezifische EMV-Störquellen, nicht zugelassene Funkgeräte, in ISM-Bändern arbeitende Geräte (z. B. Hochfrequenzschweißgeräte, Lasergeräte), Funkschlüsseln, Alarmanlagen und/oder Funkschalter in Frage. Welche Störsignale auftreten können und welche Frequenzen diese Störsignale haben, hängt von den spezifischen Eigenschaften der Komponenten des Objekts ab, in dem Teilentladungen erfasst werden sollen (beispielsweise von Komponenten eines Systems aus Stromrichter und elektrischer Maschine), sowie von in der Umgebung des Objekts vorhandenen Störquellen. Eine erfindungsgemäße Sensorvorrichtung weist ein Frequenzfilter mit wenigstens einem einstellbaren Frequenzbereich auf, in dem Frequenzen von Messsignalen des Sensors der Sensorvorrichtung unterdrückt werden. Dadurch kann das Frequenzfilter flexibel an die Frequenzen von Störsignalen angepasst werden, die mit von Teilentladungen verursachten Signalen verwechselt werden können. Gegenüber einer Sensorvorrichtung mit einem Frequenzfilter, der einen festen Frequenzbereich aufweist, in dem Messsignale des Sensors unterdrückt werden, kann durch eine geeignete, den jeweiligen Störsignalen angepasste Einstellung des Frequenzfilters vermieden werden, dass durch einen unnötig weiten Frequenzbereich auch Messsignale unterdrückt werden, die auf Teilentladungen zurückgehen, und andererseits durch einen zu engen Frequenzbereich Störsignale, die außerhalb des Frequenzbereichs liegende Frequenzen aufweisen, als auf Teilentladungen zurückgehende Signale der Teilentladungen interpretiert werden.

Eine Ausgestaltung der Erfindung sieht vor, dass das Frequenzfilter als ein Hochpass mit einer einstellbaren Grenzfrequenz ausgebildet ist. Dadurch können Störsignale mit unterhalb der jeweils eingestellten Grenzfrequenz liegenden Frequenzen unterdrückt werden. Diese Ausgestaltung der Erfindung ist insbesondere zur Unterdrückung von Störsignalen geeignet, die von Spannungen einer an einem Stromrichter betriebenen elektrischen Maschine verursacht werden, da derartige Störsignale in der Regel relevante Frequenzanteile nur bis zu einer bestimmten Frequenzgrenze aufweisen, die typischerweise im Bereich von einigen 10 MHz bis zu wenigen 100 MHz liegen, wobei die Frequenzgrenze jedoch wesentlich von den jeweiligen spezifischen Eigenschaften des Systems aus Stromrichter und elektrischer Maschine abhängt.

Eine dazu alternative Ausgestaltung der Erfindung sieht vor, dass das Frequenzfilter als ein Bandpass mit wenigstens einem einstellbaren Durchlassfrequenzbereich ausgebildet ist. Dadurch können neben Störsignalen mit unterhalb einer eingestellten unteren Grenzfrequenz liegenden Frequenzen auch Störsignale mit oberhalb einer eingestellten oberen Grenzfrequenz liegenden Frequenzen unterdrückt werden. Insbesondere können neben Störsignalen mit Frequenzen, die beispielsweise von Spannungen einer an einem Stromrichter betriebenen elektrischen Maschine verursacht werden, zusätzlich Störsignale mit höheren Frequenzen unterdrückt werden, die von anderen Störquellen verursacht werden, beispielsweise hochfrequente Funkwellen oder Störsignale mit hochfrequenten Frequenzen in ISM-Bändern. Die Einstellbarkeit des wenigstens einen Durchlassfrequenzbereichs des Frequenzfilters ermöglicht, das Frequenzfilter auf die jeweils relevanten Störsignale einzustellen.

Bei einer weiteren Ausgestaltung der Erfindung weist das Frequenzfilter zum Einstellen des wenigstens einen Frequenzbereichs wenigstens eine Kapazitätsdiode auf, deren Kapazität durch eine Steuerspannung einstellbar ist. Kapazitätsdioden weisen eine elektrisch steuerbare Kapazität auf und eignen sich dadurch vorteilhaft zur Realisierung von Frequenzfiltern mit einstellbaren Frequenzbereichen, in denen Frequenzen von Signalen unterdrückt werden. Beispielsweise kann eine Kapazitätsdiode in einem Schwingkreis des Frequenzfilters verbaut werden, um die Resonanzfrequenz des Schwingkreises verändern zu können und dadurch den Frequenzbereich einstellen zu können, in dem das Frequenzfilter Signale unterdrückt.

Bei einer weiteren Ausgestaltung der Erfindung ist der wenigstens eine Frequenzbereich des Frequenzfilters manuell einstellbar. Dadurch kann das Frequenzfilter durch einen Benutzer der Sensorvorrichtung manuell auf Frequenzen jeweils relevanter Störsignale eingestellt werden.

Bei einer weiteren Ausgestaltung der Erfindung weist die Sensorvorrichtung einen Logikbaustein auf, der eingerichtet ist, automatisch Störsignale in Ausgangssignalen des Frequenzfilters zu ermitteln und den wenigstens einen Frequenzbereich auf Frequenzen ermittelter Störsignale einzustellen. Dadurch kann das Frequenzfilter automatisch auf Frequenzen jeweils relevanter Störsignale eingestellt werden.

Bei einer weiteren Ausgestaltung der Erfindung weist die Sensorvorrichtung wenigstens ein Sperrfilter auf, das Messsignale des Sensors der Sensorvorrichtung mit Frequenzen in einem Störfrequenzbereich unterdrückt. Diese Ausgestaltung der Erfindung ist insbesondere vorteilhaft, wenn bekannt ist, dass bei der Anwendung der Sensorvorrichtung Störsignale in bestimmten Frequenzbändern vorhanden sind, um diese Störsignale gezielt durch Sperrfilter zu unterdrücken.

Bei einer weiteren Ausgestaltung der Erfindung weist die Sensorvorrichtung wenigstens ein vor das Frequenzfilter geschaltete Dämpfungsglied auf. Diese Ausgestaltung der Erfindung ist insbesondere vorteilhaft, wenn der wenigstens eine Frequenzbereich, dessen Frequenzen von dem Frequenzfilter unterdrückt werden, durch sehr starke Messsignale des Sensors der Sensorvorrichtung beeinflusst wird, beispielsweise durch eine Beeinflussung der Kapazitäten von Kapazitätsdioden der Sensorvorrichtung durch hohe Spannungen an den Kapazitätsdioden, die von den dem Frequenzfilter zugeführten Messsignalen verursacht werden. Durch vor das Frequenzfilter geschaltete Dämpfungsglieder können derartige Wirkungen von starken Messsignalen des Sensors auf das Frequenzfilter vorteilhaft reduziert werden.

Bei einer weiteren Ausgestaltung der Erfindung weist der Sensor der Sensorvorrichtung eine Antenne eines Temperatursensors und eine Auskoppeleinheit zum Auskoppeln von der Antenne erfasster elektrischer Signale auf. Die Antenne des Temperatursensors kann insbesondere als eine Zuleitung des Temperatursensors ausgebildet sein oder mehrere Zuleitungen des Temperatursensors umfassen. Temperatursensoren sind insbesondere typischerweise in elektrischen Maschinen ohnehin vorhanden und ihre Zuleitungen können daher vorteilhaft als Antennen zum Erfassen elektromagnetischer Signale verwendet werden. Dabei weist der Sensor neben der Antenne des Temperatursensors vorzugsweise ferner eine Auskoppeleinheit, beispielsweise eine Frequenzweiche, zum Auskoppeln von der Antenne erfasster hochfrequenter Signale auf, um diese Signale von niederfrequenten Temperatursignalen zu trennen, die von dem Temperatursensor erfasst werden.

Bei einer weiteren Ausgestaltung der Erfindung weist die Sensorvorrichtung eine Hochfrequenz-Detektorschaltung auf, die eingerichtet ist, aus Ausgangssignalen des Frequenzfilters ein Amplitudensignal für Amplituden von Spektralanteilen der Ausgangssignale des Frequenzfilters zu ermitteln. Beispielsweise ist das Amplitudensignal ein Hüllkurvensignal, das beispielsweise zum Verlauf logarithmierter Amplituden von Spektralkomponenten der Ausgangssignale des Frequenzfilters proportional ist. Dadurch wird die Auswertung der Ausgangssignale des Frequenzfilters vorteilhaft vereinfacht. Beispielsweise weist die Sensorvorrichtung wenigstens einen Spitzenwertdetektor auf, der eingerichtet ist, einen Maximalwert des Amplitudensignals zu ermitteln. Alternativ oder zusätzlich weist die Sensorvorrichtung beispielsweise wenigstens einen Integrator auf, der eingerichtet ist, einen Referenzwert überschreitende Anteile des Amplitudensignals zu integrieren. Dadurch können vorteilhaft eine Stärke und/oder eine Leistung einer Teilentladung erfasst werden.

Bei dem erfindungsgemäßen Verfahren zum Erfassen einer Teilentladung, insbesondere in einer an einem Stromrichter betriebenen rotierenden elektrischen Maschine, mit einer erfindungsgemäßen Sensorvorrichtung werden mit dem Sensor der Sensorvorrichtung elektromagnetische Signale erfasst und das Frequenzfilter wird auf wenigstens einen Frequenzbereich eingestellt, der Frequenzen von Störsignalen aufweist. Beispielsweise wird der wenigstens eine Frequenzbereich manuell eingestellt. Alternativ oder zusätzlich kann automatisch nach Störsignalen in Ausgangssignalen des Frequenzfilters gesucht und der wenigstens eine Frequenzbereich automatisch auf Frequenzen erkannter Störsignale eingestellt oder erweitert werden. Im Falle der Verwendung der Sensorvorrichtung zum Erfassen von Teilentladungen in einer an einem Stromrichter betriebenen rotierenden elektrischen Maschine kann ferner der wenigstens eine Frequenzbereich automatisch in Abhängigkeit von wenigstens einer Kenngröße des Stromrichters und/oder der elektrischen Maschine eingestellt werden. Beispielsweise wird die wenigstens eine Kenngröße ermittelt, indem wenigstens eine maschinenlesbare Fabrikatbezeichnung einer Komponente des Stromrichters oder der elektrischen Maschine gelesen und ausgewertet wird. Die Vorteile des erfindungsgemäßen Verfahrens entsprechen oben bereits genannten Vorteilen einer erfindungsgemäßen Sensorvorrichtung.

Die oben beschriebenen Eigenschaften, Merkmale und Vorteile dieser Erfindung sowie die Art und Weise, wie diese erreicht werden, werden klarer und deutlicher verständlich im Zusammenhang mit der folgenden Beschreibung von Ausführungsbeispielen, die im Zusammenhang mit den Zeichnungen näher erläutert werden. Dabei zeigen:
FIG 1 ein Blockdiagramm eines Stromrichters, einer elektrischen Maschine und einer Sensorvorrichtung zum Erfassen von Teilentladungen in der elektrischen Maschine,
FIG 2 eine Schnittdarstellung einer elektrischen Maschine und einer Sensorvorrichtung zum Erfassen von Teilentladungen in der elektrischen Maschine,
FIG 3 ein Blockschaltbild eines Ausführungsbeispiels einer Sensorvorrichtung zum Erfassen einer Teilentladung,
FIG 4 einen Schaltplan eines ersten Ausführungsbeispiels eines Frequenzfilters,
FIG 5 einen Schaltplan eines zweiten Ausführungsbeispiels eines Frequenzfilters.

Einander entsprechende Teile sind in den Figuren mit denselben Bezugszeichen versehen.

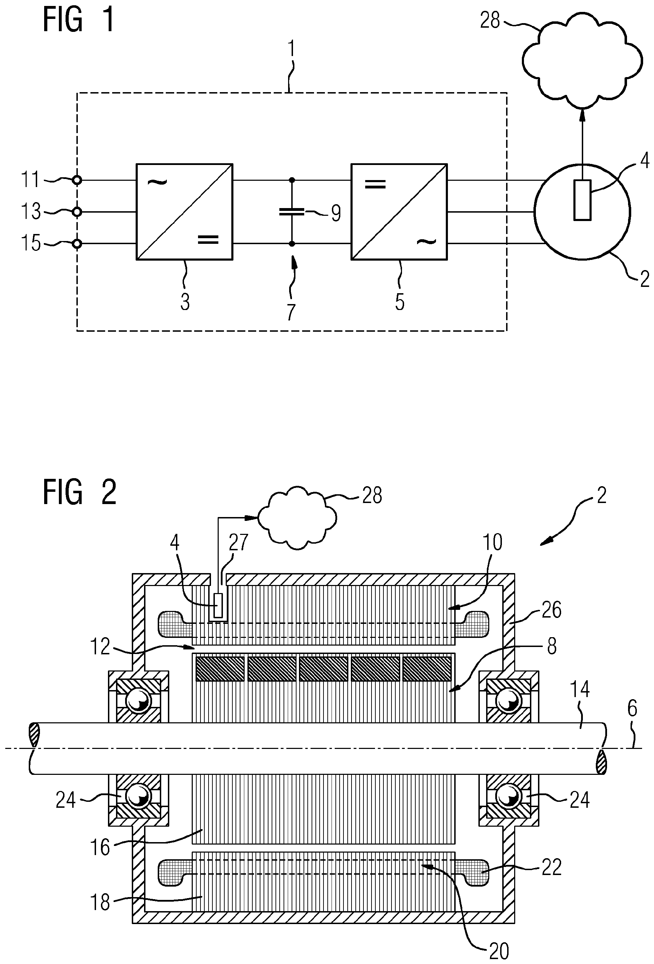

Figur 1 zeigt ein Blockdiagramm eines Stromrichters 1, einer rotierenden elektrischen Maschine 2 und einer Sensorvorrichtung 4 zum Erfassen von Teilentladungen in der elektrischen Maschine 2.

Der Stromrichter 1 ist als ein Frequenzumrichter mit einem Gleichrichter 3, einem Wechselrichter 5 und einem Gleichspannungszwischenkreis 7 ausgebildet. Der Gleichrichter 3 ist über Stromrichteranschlüsse 11, 13, 15 des Stromrichters 1 mit den Phasen eines Wechselstromnetzes verbindbar. Der Gleichspannungszwischenkreis 7 ist zwischen den Gleichrichter 3 und den Wechselrichter 5 geschaltet und weist einen Zwischenkreiskondensator 9 als Energiespeicher auf, um eine Zwischenkreisspannung des Gleichspannungszwischenkreises 7 annähernd konstant zu halten. Die Ausgänge des Wechselrichters 5 sind mit Statorwicklungen 20 der elektrischen Maschine 2 verbunden. Der Gleichrichter 3 und der Wechselrichter 5 weisen jeweils elektronische Schalteinheiten auf, um in aus dem Stand der Technik bekannter Weise mit dem Gleichrichter 3 eine an die Stromrichteranschlüsse 11, 13, 15 angelegte Eingangswechselspannung des Stromrichters 1 in die Zwischenkreisspannung des Gleichspannungszwischenkreises 7 und mit dem Wechselrichter 5 die Zwischenkreisspannung in eine Ausgangswechselspannung des Stromrichters 1 umzuwandeln. Die elektrische Maschine 2 ist als ein Elektromotor ausgebildet, der von dem Stromrichter 1 gesteuert und mit elektrischer Energie versorgt wird.

Figur 2 zeigt eine Schnittdarstellung der elektrischen Maschine 2 und der Sensorvorrichtung 4. Die elektrische Maschine 2 ist exemplarisch als permanenterregte Synchronmaschine ausgeführt, wobei die Erfindung nicht auf diesen Maschinentyp beschränkt ist, sondern die Erfassung von Teilentladungen auch in anderen Maschinen, beispielsweise in Asynchronmaschinen, zum Gegenstand hat.

Die elektrische Maschine 2 weist einen um eine Rotationsachse 6 rotierbaren Rotor 8 und einen den Rotor 8 umgebenden Stator 10 auf, wobei sich zwischen dem Rotor 8 und dem Stator 10 ein Spalt 12, der insbesondere als Luftspalt ausgeführt ist, befindet. Die Rotationsachse 6 definiert eine Axialrichtung. Der Rotor 8 umfasst eine Welle 14 und ein Rotorblechpaket 16. Der Stator 10 umfasst ein Statorblechpaket 18 mit Statorwicklungen 20, wobei das Statorblechpaket 18 aus einer Vielzahl von geschichteten Elektroblechen aufgebaut ist. Die Statorwicklungen 20 verlaufen in Axialrichtung durch das Statorblechpaket 18 und bilden an den axialen Enden des Statorblechpakets 18 Wickelköpfe 22 aus. Die Welle 14 des Rotors 8 ist über Lager 24 gelagert. Der Rotor 8 und der Stator 10 sind in einem Maschinengehäuse 26 angeordnet, aus dem die Welle 14 herausragt.

Die Sensorvorrichtung 4 ist, beispielsweise in einem Kanal 27, welcher durch das Statorblechpaket 18 verläuft, im Bereich der Statorwicklungen 20 angeordnet. Die Anordnung der Sensorvorrichtung 4 ist nur schematisch dargestellt, wobei der Kanal 27 auch anders ausgeführt sein kann. Beispielsweise kann der Kanal 27 in eine andere Richtung, beispielsweise um 90° gedreht, durch das Statorblechpaket 18 verlaufend angeordnet sein. Darüber hinaus ist die Sensorvorrichtung 4 mit einer IT-Infrastruktur 28 verbunden. Die IT-Infrastruktur 28 ist beispielsweise mindestens ein lokales Computersystem und/oder eine Cloud. Die IT-Infrastruktur 28 stellt Speicherplatz, Rechenleistung und/oder Anwendungssoftware bereit. In der Cloud werden Speicherplatz, Rechenleistung und/oder Anwendungssoftware als Dienstleistung über das Internet zur Verfügung gestellt. Die digitale Datenübertragung zwischen der Sensorvorrichtung 4 und der IT-Infrastruktur 28 findet drahtlos, drahtgebunden oder optisch statt. Beispielsweise werden die Daten über Bluetooth oder WLAN übertragen.

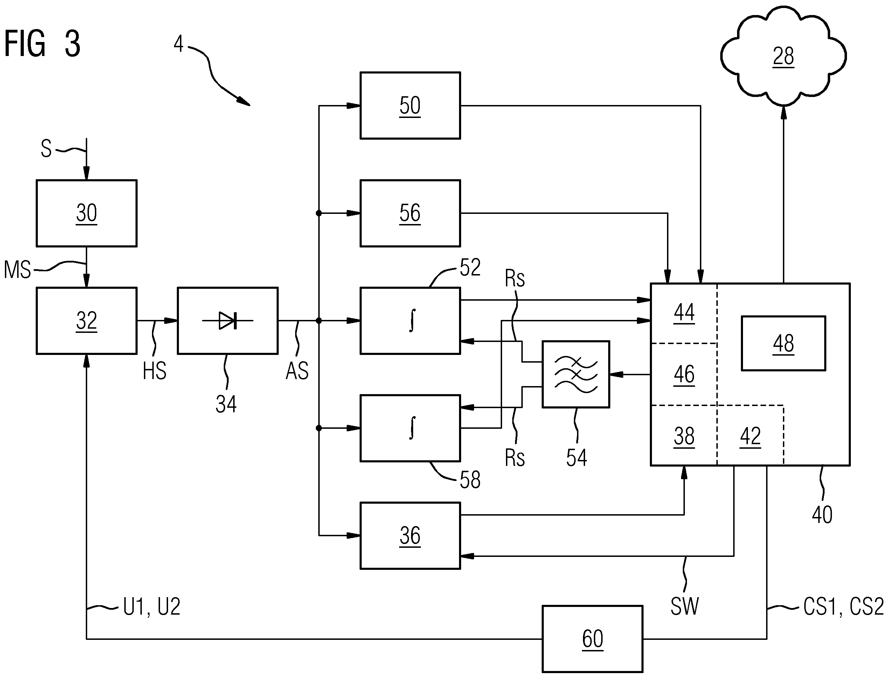

Figur 3 zeigt ein Blockschaltbild eines Ausführungsbeispiels einer Sensorvorrichtung 4 zum Erfassen von Teilentladungen.

Die Sensorvorrichtung 4 umfasst einen Sensor 30, der eingerichtet ist, elektromagnetische Signale S, insbesondere gepulste hochfrequente elektromagnetische Signale, zu erfassen. Unter einem gepulsten hochfrequenten Signal ist beispielsweise ein Puls mit einer Pulsdauer von mindestens 200 ns zu verstehen, wobei der Puls beispielsweise auf ein Trägersignal aufmoduliert ist, das eine Frequenz von mindestens 20 MHz aufweist. Der Puls weist beispielsweise eine rechteckige, eine gaußförmige oder eine andere Pulsform auf. Im Fall, dass die Sensorvorrichtung 4 wie in Figur 2 in einer rotierenden elektrischen Maschine 2 angeordnet ist, werden von dem Sensor 30 insbesondere elektromagnetische Signale S erfasst, die von Teilentladungen erzeugt werden, zu deren Erfassung die Sensorvorrichtung 4 eingerichtet ist, aber auch andere elektromagnetische Signale S, die im Folgenden als Störsignale bezeichnet werden und beispielsweise von der Statorwicklungsspannungen der elektrischen Maschine 2 oder anderen Störquellen erzeugt werden. Insbesondere wenn die Statorwicklungen von einem Stromrichter 1 gespeist werden, erzeugen sie in der Regel eine Vielzahl von Störsignalen, die auf Schaltvorgänge des Stromrichters 1 zurückgehen und Spektralanteile mit Frequenzen bis weit in den MHz-Bereich hinein aufweisen. Als weitere Störquellen kommen beispielsweise Funkdienste wie Rundfunk, Betriebsfunk oder Mobilfunk, unspezifische EMV-Störquellen, nicht zugelassene Funkgeräte, in ISM-Bändern arbeitende Geräte (z. B. Hochfrequenzschweißgeräte, Lasergeräte), Funkschlüsseln, Alarmanlagen und/oder Funkschalter in Frage.

Der Sensor 30 umfasst beispielsweise eine Antenne eines Temperatursensors, welcher einen temperaturabhängigen Widerstand, der beispielsweise aus Platin hergestellt ist, und Zuleitungen umfasst, wobei die Antenne von den Zuleitungen des Temperatursensors gebildet wird. In diesem Fall weist der Sensor 30 beispielsweise ferner eine Auskoppeleinheit, beispielsweise eine Frequenzweiche, zum Auskoppeln von der Antenne erfasster hochfrequenter Signale auf, um diese Signale von niederfrequenten Temperatursignalen zu trennen, die von dem Temperatursensor erfasst werden. Alternativ ist der Sensor 30 als kapazitive Kopplungsvorrichtung, welche mindestens einen Koppelkondensator aufweist, als induktive Kopplungsvorrichtung, welche mindestens eine Koppelspule aufweist, als Richtkoppler oder als ein anderer Sensor ausgestaltet, der zum Erfassen elektromagnetischer Signale geeignet ist, die von Teilentladungen erzeugt werden.

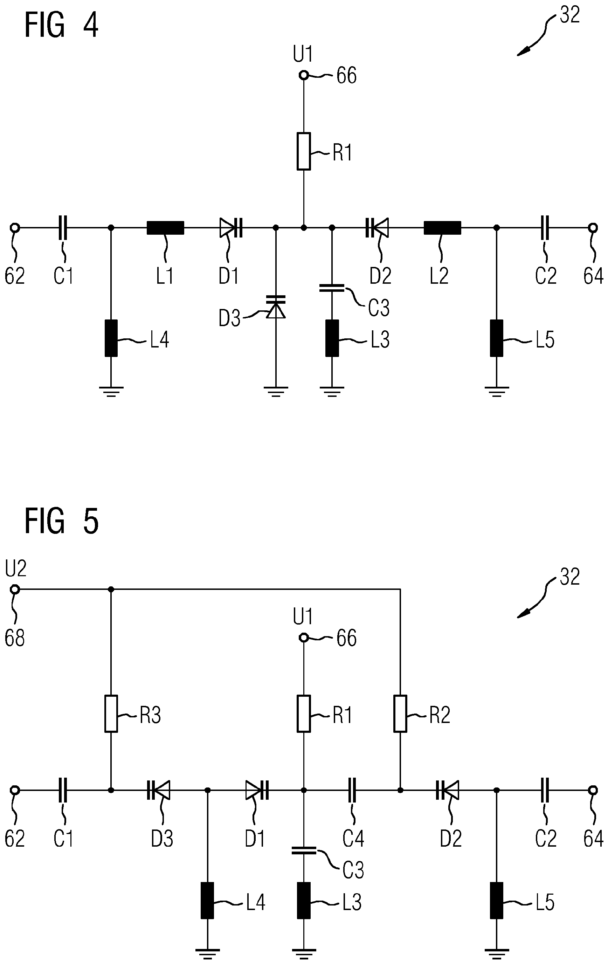

Ferner weist die Sensorvorrichtung 4 ein Frequenzfilter 32 auf, das eingerichtet ist, Messsignale MS des Sensors 30 mit Frequenzen in wenigstens einem Frequenzbereich zu unterdrücken, wobei der wenigstens eine Frequenzbereich einstellbar ist. Ausführungsbeispiele derartiger Frequenzfilter 32 sind in den Figuren 4 und 5 dargestellt.

Mit Hilfe einer Hochfrequenz-Detektorschaltung 34 wird aus den hochfrequenten Ausgangssignalen HS des Frequenzfilters 32 ein Amplitudensignal AS für Amplituden von Spektralanteilen der Ausgangssignale HS des Frequenzfilters 32 ermittelt. Beispielsweise ist das Amplitudensignal AS ein Hüllkurvensignal, das beispielsweise zum Verlauf logarithmierter Amplituden von Spektralkomponenten der Ausgangssignale AS des Frequenzfilters 32 proportional ist. Die Hochfrequenz-Detektorschaltung 34 weist beispielsweise zumindest eine, insbesondere temperaturkompensierte, Schottky-Diode auf und ist beispielsweise bis zu einer Frequenz von 1 GHz verwendbar.

Das Amplitudensignal AS wird von einem Schwellenwertschalter 36 weiter verarbeitet. Der Schwellenwertschalter 36 ist als Komparator ausgestaltet, wobei der Komparator bei einer steigenden Flanke des Amplitudensignals AS ab einem, insbesondere einstellbaren, Schwellenwert einen ersten Spannungswert ausgibt und bei einer fallenden Flanke des Amplitudensignals AS unterhalb des Schwellenwerts einen zweiten Spannungswert ausgibt, welcher vom ersten Spannungswert verschieden ist. Beispielsweise wird vom Komparator eine logische Eins ausgegeben, wenn das Amplitudensignal AS den Schwellenwert überschreitet, und eine logische Null ausgegeben, wenn das Amplitudensignal AS den Schwellenwert unterschreitet. Beispielsweise gibt der Komparator ein CMOS- oder ein TTL-Signal aus. Alternativ ist der Schwellenwertschalter 36 als Schmitt-Trigger ausgeführt.

Der Ausgang des Schwellenwertschalters 36 ist mit einer Schnittstelle 38 eines programmierbaren Logikbausteins 40, welcher als Mikrocontroller ausgeführt ist, verbunden. Alternativ ist der programmierbare Logikbaustein 40 als Field Programmable Gate Array (FPGA) oder andersartig ausgeführt. Überschreitet das Amplitudensignal AS den Schwellenwert, gibt der Komparator beispielsweise eine logische Eins aus und es wird eine Teilentladung erfasst. Über einen Digital-Analog-Umsetzer 42 im Mikrocontroller wird ein Schwellenwertsignal SW an den Schwellenwertschalter 36 ausgegeben. Ferner weist der Mikrocontroller einen, insbesondere mehrkanaligen, Analog-Digital-Umsetzer 44 und einen Pulsweiten-Modulator 46 auf. Durch eine Steuereinheit 48, welche dem Mikrocontroller zugewiesen ist, wird der Verfahrensablauf gesteuert. Die ermittelten Daten, insbesondere die Anzahl und die Zeitdauer der Teilentladungen, werden zumindest teilweise an die IT-Infrastruktur 28 gesendet. Die Daten werden mit Hilfe einer auf der IT-Infrastruktur 28 aufsetzenden IoT-Plattform weiter verarbeitet, wobei von der IoT-Plattform ein Service zur Verfügung gestellt wird. Ein derartiger Service ist beispielsweise das Auslösen einer Benachrichtigung bei einer definierten Veränderung der Daten.

Das Amplitudensignal AS wird, neben dem Schwellenwertschalter 36, von zwei Spitzenwertdetektoren 50, 56 sowie von zwei Integratoren 52, 58 weiterverarbeitet. Die Spitzenwertdetektoren 50, 56 und Integratoren 52, 58 werden im Wechsel betrieben. Im Folgenden wird der Fall betrachtet, dass ein erster Spitzenwertdetektor 50 und ein erster Integrator 52, insbesondere durch einen hochohmigen Abschluss, aktiviert sind, während ein zweiter Spitzenwertdetektor 56 und ein zweiter Integrator 58, insbesondere durch einen niederohmigen Abschluss, deaktiviert sind. Überschreitet das Amplitudensignal AS auf einer steigenden Flanke den Schwellenwert, wird ein Messvorgang ausgelöst. Unterschreitet das Amplitudensignal AS daraufhin auf einer fallenden Flanke den Schwellenwert, wird der Messvorgang beendet.

Während des Messvorgangs wird vom aktiven Spitzenwertdetektor 50 ein Spitzenwert des Amplitudensignals AS ermittelt und über den Analog-Digital-Umsetzer 44 an den Mikrocontroller weitergeleitet. Der Analog-Digital-Umsetzer 44 des Mikrocontrollers weist mehrere Eingangskanäle auf. Alternativ weist der Mikrocontroller zwei separate Analog-Digital-Umsetzer 44 auf oder mindestens ein Analog-Digital-Umsetzer 44 ist als separater Halbleiterbaustein ausgeführt und über Leitungen mit dem Mikrocontroller verbunden. Nach dem Ende des Messvorgangs wird der aktive Spitzenwertdetektor 50, beispielsweise durch einen niederohmigen Abschluss, zurückgesetzt. Aus dem Ausgangssignal des Spitzenwertdetektors 50 wird im Mikrocontroller ein Maximalwert der Amplituden von Spektralanteilen der Ausgangssignale HS des Frequenzfilters 32 ermittelt und gespeichert. Dadurch kann eine Stärke einer Teilentladung erfasst werden.

Darüber hinaus wird vom aktiven Integrator 52 während des Messvorgangs der Teil des Amplitudensignals AS, der über einem mit Hilfe des Mikrocontrollers einstellbaren Referenzwert liegt, integriert. Weist das Amplitudensignal AS einen Gleichspannungsoffset auf, wird der Referenzwert so gewählt, dass der Gleichspannungsoffset keinen Beitrag zum Ausgangssignal des Integrators 52 liefert. Der Referenzwert wird über ein Referenzsignal Rs, welches von einem Pulsweiten-Modulator 46 des Mikrocontrollers über ein Tiefpassfilter 54 dem Integrator 52 zur Verfügung gestellt wird, eingestellt. Das Tiefpassfilter 54 ist beispielsweise als RC-Filter oder LC-Filter ausgeführt. Aus dem Ausgangssignal des Integrators 52 wird im Mikrocontroller eine, insbesondere mittlere, Leistung der Ausgangssignale HS des Frequenzfilters 32 ermittelt und gespeichert.

Im Mikrocontroller wird, beispielsweise durch einen Impulszähler, jedes Überschreiten des Schwellenwerts auf einer steigenden Flanke des Amplitudensignals AS gezählt sowie ein Zeitpunkt des Überschreitens des Schwellenwerts als ein erster Zeitpunkt erfasst und gespeichert. Bei einem darauf folgenden Unterschreiten des Schwellenwerts auf einer fallenden Flanke des Amplitudensignals AS wird der Zeitpunkt des Unterschreitens des Schwellenwerts als ein zweiter Zeitpunkt erfasst und gespeichert. Aus dem ersten Zeitpunkt und dem zweiten Zeitpunkt wird eine Zeitdauer des Überschreitens des Schwellenwerts ermittelt. Dadurch können eine Anzahl, Zeitpunkte und Zeitdauern von Teilentladungen erfasst werden.

Ferner werden der gerade nicht genutzte zweite Spitzenwertdetektor 56 und der zweite Integrator 58, insbesondere durch einen hochohmigen Abschluss, aktiviert, damit von diesen eine neue Teilentladung verarbeitbar ist. Darüber hinaus beginnt die Analog-Digital-Umsetzung der Ausgangssignale des ersten Spitzenwertdetektors 50 und des ersten Integrators 52. Nach dem Ende der Analog-Digital-Umsetzung werden der erste Spitzenwertdetektor 50 und der erste Integrator 52, insbesondere durch einen niederohmigen Abschluss, zurückgesetzt. Durch den alternierenden Betrieb der Spitzenwertdetektoren 50, 56 und der Integratoren 52, 58 erfolgt eine parallelisierte analoge Signalverarbeitung, welche den Mikrocontroller entlastet.

Bei einem alternativen Ausführungsbeispiel weist die Sensorvorrichtung 4 statt je zweier Spitzenwertdetektoren 50, 56 und Integratoren 52, 58 nur einen Spitzenwertdetektor 50 und einen Integrator 52 auf. Bei weiteren alternativen Ausführungsbeispielen weist die Sensorvorrichtung 4 weder einen Spitzenwertdetektor 50, 56 noch einen Integrator 52, 58 auf. Weiter alternativ kann vorgesehen sein, dass die Sensorvorrichtung 4 entweder nur wenigstens einen Spitzenwertdetektor 50, 56 und keinen Integrator 52, 58 oder nur wenigstens einen Integrator 52, 58 und keinen Spitzenwertdetektor 50, 56 aufweist.

Der Logikbaustein 40 ist ferner dazu eingerichtet, wenigstens ein Einstellsignal CS1, CS2 zu erzeugen, mit dem der wenigstens eine Frequenzbereich des Frequenzfilters 32 eingestellt wird. Beispielsweise wird jedes Einstellsignal CS1, CS2 als eine Ausgangsspannung von dem Digital-Analog-Umsetzer 42 ausgegeben, um wenigstens eine Steuerspannung U1, U2 für das Frequenzfilter 32 zu erzeugen. Um das wenigstens eine Einstellsignal CS1, CS2 zu einer Steuerspannung U1, U2 zu verstärken, kann ein Gleichspannungswandler 60 vorgesehen sein. Wenn ein Einstellsignal CS1, CS2 bereits eine ausreichend hohe Ausgangsspannung des Digital-Analog-Umsetzers 42 ist, kann es auch direkt als Steuerspannung U1, U2 verwendet werden.

Die Sensorvorrichtung 4 kann außerdem wenigstens ein (nicht dargestelltes) Sperrfilter aufweisen, das Messsignale MS des Sensors 30 mit Frequenzen in einem Störfrequenzbereich unterdrückt. Ferner kann die Sensorvorrichtung 4 wenigstens ein vor das Frequenzfilter 32 geschaltetes (ebenfalls nicht dargestelltes) Dämpfungsglied aufweisen, mit dem sehr große Messsignale MS des Sensors 30 verkleinert werden, um eine Beeinflussung des wenigstens einen Frequenzbereichs, dessen Frequenzen von dem Frequenzfilter 32 unterdrückt werden, durch die Messsignale MS zu reduzieren.

Figur 4 zeigt einen Schaltplan eines ersten Ausführungsbeispiels eines Frequenzfilters 32 einer erfindungsgemäßen Sensorvorrichtung 4.

Das Frequenzfilter 32 ist als ein Bandpass mit einem einstellbaren Durchlassfrequenzbereich ausgeführt. Das Frequenzfilter 32 umfasst Kapazitätsdioden D1, D2, D3, Kondensatoren C1, C2, C3, Spulen L1, L2, L3, L4, L5, einen Widerstand R1, einen Eingangsanschluss 62, einen Ausgangsanschluss 64 und einen Steueranschluss 66.

Der Kondensator C1, die Spule L1 und die Kapazitätsdiode D1 sind in Reihe geschaltet und bilden einen ersten Schwingkreis. Der Kondensator C2, die Spule L2 und die Kapazitätsdiode D2 sind in Reihe geschaltet und bilden einen zweiten Schwingkreis. Der erste Schwingkreis und der zweite Schwingkreis sind in Reihe zwischen den Eingangsanschluss 62 und den Ausgangsanschluss 64 geschaltet, wobei der Kondensator C1 mit dem Eingangsanschluss 62 verbunden ist und der Kondensator C2 mit dem Ausgangsanschluss 64 verbunden ist. Die Spule L1 ist zwischen den Kondensator C1 und die Kapazitätsdiode D1 geschaltet, die Spule L2 ist zwischen den Kondensator C2 und die Kapazitätsdiode D2 geschaltet.

Die Kathoden der Kapazitätsdioden D1, D2 des ersten Schwingkreises und des zweiten Schwingkreises sind miteinander verbunden. Ferner sind die Kathoden der Kapazitätsdioden D1, D2 des ersten Schwingkreises und des zweiten Schwingkreises mit der Kathode der Kapazitätsdiode D3 verbunden, deren Anode auf einem Erdpotential liegt. Außerdem sind die Kathoden der Kapazitätsdioden D1, D2 des ersten Schwingkreises und des zweiten Schwingkreises über einen von dem Kondensator C3 und der Spule L3 gebildeten dritten Schwingkreis mit dem Erdpotential verbunden.

Die Verbindung des Kondensators C1 und der Spule L1 ist über die Spule L4 mit dem Erdpotential verbunden. Die Verbindung des Kondensators C2 und der Spule L2 ist über die Spule L5 mit dem Erdpotential verbunden.

Ein erster Pol des Widerstands R1 ist mit dem Steueranschluss 66 verbunden. Der zweite Pol des Widerstands R1 ist mit den Kathoden der Kapazitätsdioden D1, D2, D3 verbunden. An den Steueranschluss 66 wird eine Steuerspannung U1 gelegt. Mit der Steuerspannung U1 werden die Kapazitäten der Kapazitätsdioden D1, D2, D3 und darüber die Resonanzfrequenzen der Schwingkreise und der Durchlassfrequenzbereich des Frequenzfilters 32 eingestellt.

Figur 5 zeigt einen Schaltplan eines zweiten Ausführungsbeispiels eines Frequenzfilters 32 einer erfindungsgemäßen Sensorvorrichtung 4.

Das Frequenzfilter 32 ist als ein symmetrischer Hochpass mit einer einstellbaren Grenzfrequenz ausgeführt. Das Frequenzfilter 32 umfasst Kapazitätsdioden D1, D2, D3, Kondensatoren C1, C2, C3, C4, Spulen L3, L4, L5, Widerstände R1, R2, R3, einen Eingangsanschluss 62, einen Ausgangsanschluss 64 und Steueranschlüsse 66, 68.

Das in Figur 5 dargestellte Frequenzfilter 32 unterscheidet sich von dem in Figur 4 dargestellten Frequenzfilter 32 unter anderem dadurch, dass die Spulen L1, L2 entfallen, zwischen die Kapazitätsdioden D1 und D2 ein Kondensator C4 geschaltet ist und die Kapazitätsdiode D3 zwischen den Kondensator C1 und die Kapazitätsdiode D1 geschaltet ist, wobei die Anoden der Kapazitätsdioden D1 und D3 miteinander und über die Spule L4 mit dem Erdpotential verbunden sind. Der von dem Kondensator C3 und der Spule L3 gebildete Schwingkreis ist mit der Kathode der Kapazitätsdiode D1 und dem Erdpotential verbunden.

Ferner unterscheidet sich das in Figur 5 dargestellte Frequenzfilter 32 von dem in Figur 4 dargestellten Frequenzfilter 32 dadurch, dass es zwei Steueranschlüsse 66, 68 aufweist. Der Steueranschluss 66 ist über den Widerstand R1 mit der Kathode der Kapazitätsdiode D1 verbunden. Der Steueranschluss 68 ist über den Widerstand R2 mit der Kathode der Kapazitätsdiode D2 und über den Widerstand R3 mit der Kathode der Kapazitätsdiode D3 verbunden. An den Steueranschluss 66 wird eine erste Steuerspannung U1 gelegt, an den Steueranschluss 68 wird eine zweite Steuerspannung U2 gelegt. Mit den Steuerspannungen U1, U2 werden die Kapazitäten der Kapazitätsdioden D1, D2, D3 und darüber die Grenzfrequenz des Frequenzfilters 32 eingestellt.

Erfindungsgemäß wird im Fall des in Figur 4 dargestellten Ausführungsbeispiels der Durchlassfrequenzbereich beziehungsweise im Fall des in Figur 5 dargestellten Ausführungsbeispiels die Grenzfrequenz des Frequenzfilters 32 derart eingestellt, dass das Frequenzfilter 32 wenigstens einen Frequenzbereich aufweist, in dem es Frequenzen von Störsignalen unterdrückt. Der Frequenzbereich wird beispielsweise manuell eingestellt. Alternativ oder zusätzlich kann der Frequenzbereich automatisch in Abhängigkeit von wenigstens einer Kenngröße des Stromrichters 1 und/oder der elektrischen Maschine 2 eingestellt werden, beispielsweise anhand von maschinenlesbaren Fabrikatbezeichnungen von Komponenten des Stromrichters 1 und/oder der elektrischen Maschine 2, die von dem Logikbaustein 40 oder einer Anwendungssoftware der IT-Infrastruktur 28 gelesen und ausgewertet werden. Weiter alternativ oder zusätzlich kann von dem Logikbaustein 40 oder einer Anwendungssoftware der IT-Infrastruktur 28 automatisch nach Störsignalen in den Ausgangssignalen HS des Frequenzfilters 32 und/oder in dem Amplitudensignal AS der Hochfrequenz-Detektorschaltung 34 gesucht und der wenigstens eine Frequenzbereich automatisch auf Frequenzen erkannter Störsignale eingestellt werden.

Obwohl die Erfindung im Detail durch bevorzugte Ausführungsbeispiele näher illustriert und beschrieben wurde, so ist die Erfindung nicht durch die offenbarten Beispiele eingeschränkt und andere Variationen können vom Fachmann hieraus abgeleitet werden, ohne den Schutzumfang der Erfindung zu verlassen.

## Patentansprüche

1. Sensorvorrichtung (4) zum Erfassen einer Teilentladung, die Sensorvorrichtung (4) umfassend
- einen Sensor (30), der eingerichtet ist, elektromagnetische Signale (S) zu erfassen, und
- ein Frequenzfilter (32), das eingerichtet ist, Messsignale (MS) des Sensors (30) mit Frequenzen in wenigstens einem Frequenzbereich zu unterdrücken,
- wobei der wenigstens eine Frequenzbereich einstellbar ist.

2. Sensorvorrichtung (4) nach Anspruch 1, wobei das Frequenzfilter (32) als ein Hochpass mit einer einstellbaren Grenzfrequenz ausgebildet ist.

3. Sensorvorrichtung (4) nach Anspruch 1, wobei das Frequenzfilter (32) als ein Bandpass mit wenigstens einem einstellbaren Durchlassfrequenzbereich ausgebildet ist.

4. Sensorvorrichtung (4) nach einem der vorhergehenden Ansprüche, wobei das Frequenzfilter (32) zum Einstellen des wenigstens einen Frequenzbereichs wenigstens eine Kapazitätsdiode (D1, D2, D3) aufweist, deren Kapazität durch eine Steuerspannung (U1, U2) einstellbar ist.

5. Sensorvorrichtung (4) nach einem der vorhergehenden Ansprüche, wobei der wenigstens eine Frequenzbereich manuell einstellbar ist.

6. Sensorvorrichtung (4) nach einem der vorhergehenden Ansprüche mit einem Logikbaustein (40), der eingerichtet ist, automatisch Störsignale in Ausgangssignalen (HS) des Frequenzfilters (32) zu ermitteln und den wenigstens einen Frequenzbereich auf Frequenzen ermittelter Störsignale einzustellen.

7. Sensorvorrichtung (4) nach einem der vorhergehenden Ansprüche mit wenigstens einem Sperrfilter, das Messsignale (MS) des Sensors (30) mit Frequenzen in einem Störfrequenzbereich unterdrückt.

8. Sensorvorrichtung (4) nach einem der vorhergehenden Ansprüche mit wenigstens einem vor das Frequenzfilter (32) geschalteten Dämpfungsglied.

9. Sensorvorrichtung (4) nach einem der vorhergehenden Ansprüche, wobei der Sensor (30) eine Antenne eines Temperatursensors und eine Auskoppeleinheit zum Auskoppeln von der Antenne erfasster elektrischer Signale aufweist.

10. Sensorvorrichtung (4) nach einem der vorhergehenden Ansprüche mit einer Hochfrequenz-Detektorschaltung (34), die eingerichtet ist, aus Ausgangssignalen (HS) des Frequenzfilters (32) ein Amplitudensignal (AS) für Amplituden von Spektralanteilen der Ausgangssignale (HS) des Frequenzfilters (32) zu ermitteln.

11. Sensorvorrichtung (4) nach Anspruch 10 mit wenigstens einem Spitzenwertdetektor (50, 56), der eingerichtet ist, einen Maximalwert des Amplitudensignals (AS) zu ermitteln.

12. Sensorvorrichtung (4) nach Anspruch 10 oder 11 mit wenigstens einem Integrator (52, 58), der eingerichtet ist, einen Referenzwert überschreitende Anteile des Amplitudensignals (AS) zu integrieren.

13. Verfahren zum Erfassen einer Teilentladung mit einer Sensorvorrichtung (4) nach einem der vorhergehenden Ansprüche, wobei
- mit dem Sensor (30) der Sensorvorrichtung (4) elektromagnetische Signale (S) erfasst werden
- und das Frequenzfilter (32) auf wenigstens einen Frequenzbereich eingestellt wird, der Frequenzen von Störsignalen aufweist.

14. Verfahren nach Anspruch 13, wobei der wenigstens eine Frequenzbereich manuell eingestellt wird oder automatisch nach Störsignalen in Ausgangssignalen des Frequenzfilters (32) gesucht wird und der wenigstens eine Frequenzbereich automatisch auf Frequenzen erkannter Störsignale eingestellt wird.

15. Verwendung einer Sensorvorrichtung (4) nach einem der Ansprüche 1 bis 12 zum Erfassen einer Teilentladung in einer an einem Stromrichter (1) betriebenen rotierenden elektrischen Maschine (2).
